Europäisches Patentamt

European Patent Office

Office européen des brevets

(11) Veröffentlichungsnummer: **0 037 087 B1**

(12) # EUROPÄISCHE PATENTSCHRIFT

(45) Veröffentlichungstag der Patentschrift:
15.02.84

(51) Int. Cl.³: **H 02 J 3/18, H 03 K 17/13**

(21) Anmeldenummer: **81102295.3**

(22) Anmeldetag: **26.03.81**

(54) **Verfahren und Vorrichtung zum überschwingungsfreien Ein- und Abschalten eines Kondensators zwischen zwei Leitern eines Wechselspannungsnetzes.**

(30) Priorität: **31.03.80 DE 3012511**

(43) Veröffentlichungstag der Anmeldung:
**07.10.81 Patentblatt 81/40**

(45) Bekanntmachung des Hinweises auf die Patenterteilung:
**15.02.84 Patentblatt 84/7**

(84) Benannte Vertragsstaaten:
**CH DE FR GB LI SE**

(56) Entgegenhaltungen:
**DE - A - 2 303 939**
**DE - A - 2 816 361**
**US - A - 4 162 442**

**ASEA JOURNAL, Band 44, Nr. 6, 1971, Seiten 180-184,
Vasteras, SE. H. FRANK et al.: "Power-factor correction
with thyristor-controlled capacitors"**

(73) Patentinhaber: **SIEMENS AKTIENGESELLSCHAFT,
Berlin und München Wittelsbacherplatz 2,
D-8000 München 2 (DE)**

(72) Erfinder: **Hochstetter, Werner, Dipl.-Ing., Stettiner
Strasse 22, D-8520 Erlangen (DE)**
Erfinder: **Schmid, Eberhard, Dipl.-Ing., Sebalder
Strasse 28, D-8524 Dormitz (DE)**

ACTORUM AG

## Verfahren und Vorrichtung zum überschwingungsfreien Ein- und Abschalten eines Kondensators zwischen zwei Leitern eines Wechselspannungsnetzes

Die Erfindung betrifft ein Verfahren zum überschwingungsfreien Ein- und Abschalten eines Kondensators zwischen zwei Leitern eines Wechselspannungsnetzes mit den im Oberbegriff des Anspruches 1 angegebenen Merkmalen. Die Erfindung betrifft ferner eine Vorrichtung zur Durchführung dieses Verfahrens.

An ein Wechselspannungsnetz angeschlossene Verbraucher stellen für das Netz häufig eine induktive Last dar, deren schwankende Blindleistungsaufnahme zu störenden Rückwirkungen im Wechselspannungsnetz führt. Zur Kompensation dieser Blindleistung kann zwischen den Phasen des Wechselspannungsnetzes eine Kondensatorbatterie angeordnet werden, wobei je nach der Grösse der aufzubringenden Kompensationsblindleistung einige oder alle Teilkondensatoren der Batterie über entsprechende, mit den Teilkondensatoren in Reihe liegende Schalter zwischen die Leiter geschaltet werden. Zum Abschalten der Kondensatoren werden die Schalter beim Stromnulldurchgang geöffnet. Die Kondensatoren bleiben dann zunächst auf dem Scheitelwert der Spannung zwischen den beiden Leitern (Leiterspannung) aufgeladen und es treten keine Ausschaltvorgänge auf. Auch beim Einschalten der Kondensatoren (Schliessen der Schalter) können Schaltströme und Einschwingvorgänge weitgehend vermieden werden, wenn die Kondensatoren auf den Scheitelwert der Leiterspannung aufgeladen sind und die Schalter gerade zu dem Zeitpunkt geschlossen werden, an dem die Leiterspannung den entsprechenden Scheitelwert erreicht, d.h. die Spannung am zunächst geöffneten Schalter Null ist. Aus Sicherheitsgründen muss jedoch meistens dafür gesorgt werden, dass bei abgeschaltetem Kondensator die Kondensatorspannung abklingt. Dann muss aber vor dem darauffolgenden Wiedereinschalten des Kondensators dieser wieder auf die Scheitelspannung aufgeladen werden. Unter «Einschalten des Kondensators» wird dabei verstanden, dass die Kondensatorbelegungen für die betriebsmässige Blindleistungskompensation — nicht zum Auf- und Entladen der Kondensatoren — auf Spannung gelegt werden.

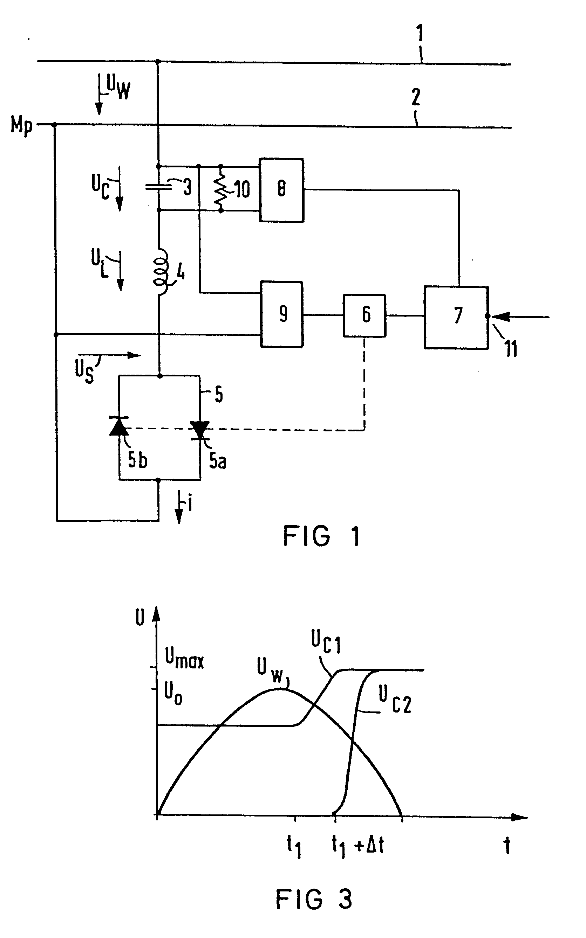

Als Schalter können vorzugsweise antiparallel geschaltete Thyristoren verwendet werden, denen zur Begrenzung des Stromanstieges eine Drosselspule vorgeschaltet ist. Aus der DE-OS Nr. 2303939 ist eine derartige Schaltung zur Durchführung des eingangs genannten Verfahrens bekannt, bei der zum Auf- und Entladen des Kondensators parallel zum Kondensator eine Reihenschaltung aus einem Hilfsthyristorschalter und einer über eine Induktivität zugeschalteten Spannungsquelle vorgesehen ist. Innerhalb der ersten Viertelperiode nach Abschalten des Kondensators wird durch Zündung des Hilfsschalters der Kondensator auf Null entladen, innerhalb einer Viertelperiode vor dem gewünschten betriebsmässigen Einschalten des Kondensators wird durch erneutes Zünden des Hilfsschalters der Kondensator auf die Scheitelspannung aufgeladen. Da der Kondensator in diesem Fall vollkommen entladen ist und auf die vorgegebene Scheitelspannung aufgeladen werden muss, liegt für den Hilfsthyristorschalter die Phasenlage («Ladeschliesswinkel») des Auflade-Zündzeitpunktes bezüglich der Netzwechselspannung hierbei fest. In Fig. 1 dieser Offenlegungsschrift ist jedoch auch eine Schaltung angegeben, bei der zum Auf- und Entladen des Kondensators nur ein einziger Thyristorschalter erforderlich ist und der Kondensator von der Netzwechselspannung selbst auf- und entladen wird. Die Zündzeitpunkte zum Auf- und Entladen liegen auch hierbei fest und zum betriebsmässigen Einschalten des Kondensators muss von der Zündsteuerung für den Thyristorschalter lediglich verlangt werden, dass entsprechende Einschaltimpulse nur abgegeben werden, wenn der Kondensator aufgeladen ist und die Leiterspannung den entsprechenden Scheitelwert erreicht hat, d.h. wenn die am Thyristorschalter liegende Spannung ein Minimum erreicht. Diese bekannte Schaltung weist somit die im Oberbegriff des Anspruches 1 genannten Merkmale auf, wobei nach dem Öffnen des Schalters (Abschalten des Kondensators) der Kondensator durch einen durch kurzfristige erneute Thyristorzündung gesteuerten Stromstoss vollkommen entladen wird.

Die bei der bekannten Vorrichtung vorgesehene Drosselspule stellt einen induktiven Speicher dar, der beim Einschalten des Kondensators zunächst nicht aufgeladen ist, so dass es bei einem exakt auf die Scheitelleiterspannung aufgeladenen Kondensator doch zu Einschwingvorgängen kommen kann. Es wird in dieser Offenlegungsschrift vorgeschlagen, durch Verschiebung des Aufladezündzeitpunktes in Richtung des Netzspannungsscheitelwertes die Vorladespannung des Kondensators zu vergrössern. Dadurch sollen die Bedingungen für ein ausgleichsstromfreies Einschalten des Kondensators realisiert werden.

Bei dem bekannten Verfahren werden beim Auf- und Entladen stets Stromstösse konstanter, maximaler Ladung erzeugt, die einer maximalen Oberschwingungsbelastung des Netzes entspricht.

Aus der US-A Nr. 462442 ist es bekannt, bei einer Anordnung mit einem über Thyristoren schaltbaren Kondensator zwischen den Leitern eines Wechselspannungsnetzes den Kondensator nach dem Abschalten durch einen Parallelwiderstand zu entladen, dessen Zeitkonstante ein Vielfaches der Wechselspannungsperiode beträgt. Eine vollständige Entladung findet daher nur bei langen Schaltpausen statt, während im allgemeinen eine Restladung des Kondensators vorhanden ist, die sich auf den Einschwingvorgang beim nächsten Einschalten des Kondensators auswirken muss. Vor diesem Einschalten wird der Kondensator nicht aufgeladen, vielmehr erfolgt der Einschaltbefehl, sobald Kondensator-Restspannung und Netzspannung gleich sind. Einschwingvorgänge zu Beginn jeder Einschalt-Periode lassen sich dadurch nicht vermeiden, sobald dem Kondensator eine Induktivität nachgeschaltet ist, wie dies z.B. bei Thyristorschaltern erforderlich ist.

Aufgabe der Erfindung ist es, bei einem Verfahren mit den Merkmalen des Oberbegriffes die zum Aufladen erforderlichen Stromstösse möglichst gering zu halten.

Mit dem im Anspruch 1 gekennzeichneten erfindungsgemässen Verfahren wird dies dadurch erreicht, dass der Kondensator ungesteuert nach einer Entladecharakteristik entladen wird, deren Zeitkonstante ein Vielfaches der Wechselspannungsperiode beträgt und dass für die Kondensatoraufladung der Schliesszeitpunkt des Schalters bezüglich der Netzwechselspannung, d.h. der Ladeschliesswinkel, in Abhängigkeit der Spannung am Kondensator in der Weise bestimmt wird, dass auch bei einer noch vorhandenen Kondensatorrestspannung eine Aufladung auf den Scheitelwert der betriebsmässigen Kondensatorspannung erfolgt.

Nach Abschalten des Kondensators wird dieser also nicht durch einen durch Betätigung eines Schalters gesteuerten Stromimpuls entladen. Vielmehr kann die Entladung auf natürliche Weise z.B. durch Leckströme oder einen parallel zum Kondensator angeordneten hochohmigen Entladewiderstand erfolgen, wobei die Zeitkonstante dieser Entladung gross gewählt werden kann, wenn aus Sicherheitsgründen oder anderen Gründen keine rasche Entladung des Kondensators vorgesehen ist. Dies hat den Vorteil, dass bei dem nächsten Wiedereinschalten des Kondensators noch eine erhebliche Kondensatorrestladung vorhanden ist und der zum Aufladen auf die Scheitelspannung erforderliche Ladestrom entsprechend kleiner ist. Die Steuerung des Ladestromes erfolgt dadurch, dass der Ladeschliesswinkel nicht konstant gehalten, sondern in Abhängigkeit von der genannten Kondensatorrestladung bestimmt wird. Für die Steuerung des Ladevorganges genügt es, die Spannung am Kondensator zu bestimmen und in einer Schaltersteuerung die erforderliche Phasenlage des Ladeschliesszeitpunktes bezüglich der Netzwechselspannung zu ermitteln. Da sich bei bekannter Kondensatorspannung die Netzwechselspannung aus der Spannung am Schalter ableiten lässt, kann das Schliessen des Schalters für die Aufladung auch auf die Schalterspannung anstelle der Netzwechselspannung synchronisiert werden.

Sofern zum Kompensieren einer veränderlichen Blindleistung eine Kondensatorbatterie vorgesehen ist, deren einzelne Kondensatoren jeweils über eigene Schalter stufenweise zwischen zwei Phasen des Wechselspannungsnetzes gelegt werden sollen, hängt die Wahl des geeigneten Ladeschliesswinkels vom Schwingungsverhalten des gesamten zwischen den Phasen liegenden Systems, also von der Zahl der bereits eingeschalteten Teilkondensatoren der Kondensatorbatterie und der Zahl der noch einzuschaltenden Teilkondensatoren ab. In diesem Fall können vorteilhaft diese Parameter in die Schaltersteuerung eingegeben werden, wobei die Steuerung zu jedem Parametersatz den zugehörigen optimalen Ladeschliesswinkel ermittelt.

In den Ansprüchen sind die Erfindung und deren vorteilhafte Weiterbildungen angegeben. Anhand von zwei Ausführungsbeispielen und 5 Figuren wird die Erfindung näher erläutert.

Es zeigen:
Fig. 1 eine Schaltung zum schwingungsfreien Einschalten eines Kondensators an ein Einphasen-Wechselspannungsnetz,
Fig. 2 den zeitlichen Verlauf des Kondensatorladestromes, der Kondensatorspannung und der Schalterspannung im Vergleich zur Netzwechselspannung bei Fig. 1,
Fig. 3 den Verlauf der Kondensatorspannung beim Aufladen für zwei unterschiedliche Kondensator-Restladungen,
Fig. 4 eine Anordnung zum Schalten von Kondensatoren zwischen den Leitern eines Dreiphasen-Wechselspannungsnetzes,
Fig. 5 die zeitlichen Verläufe entsprechend Fig. 2 für die Schaltung nach Fig. 4.

Nach Fig. 1 ist zwischen die Leiter 1 und 2 eines Wechselstromnetzes ein Kondensator 3 in Reihe mit einer Drosselspule 4 und einem Schalter 5 angeordnet. Sobald die Blindleistung eines (nicht dargestellten) Verbrauchers einen gewissen Wert übersteigt, soll zur Kompensation der Kondensator eingeschaltet werden. Der Schalter 5 besteht vorteilhaft aus zwei antiparallelen Thyristorventilen 5a und 5b, die von einem Steuersatz 6 gezündet werden. Der Zündwinkel für die Zündimpulse des Steuersatzes 6 wird in einer Schaltersteuerung 7 gebildet, der über eine Spannungserfassungseinrichtung 8 die am Kondensator 3 anliegende Kondensatorspannung $U_c$ zugeführt wird. Um die Ventile entsprechend dem vorgegebenen Zündwinkel bezüglich der Netzwechselspannung $U_w$ zu zünden, kann der Steuersatz 6 über ein Phasenmessglied 9 auf die Netzwechselspannung synchronisiert werden.

Bei geöffnetem Schalter 5 wird die am Kondensator 3 vorhandene Spannung $U_c$ langsam abfallen. Dies kann durch natürliche Entladung (z.B. Leckströme) geschehen, es kann aber auch eine eigene Einrichtung zur Kondensatorentladung (etwa ein hochohmiger Widerstand 10 parallel zum Kondensator 3) vorgesehen sein, damit sich z.B. aus Sicherheitsgründen bei abgeschalteter Anlage der Kondensator entladen kann. Diese Entladung erfolgt ungesteuert, also in der Regel exponentiell, mit einer Zeitkonstanten, die ein Vielfaches der Netzwechselspannungsperiode (z.B. einige Minuten) beträgt.

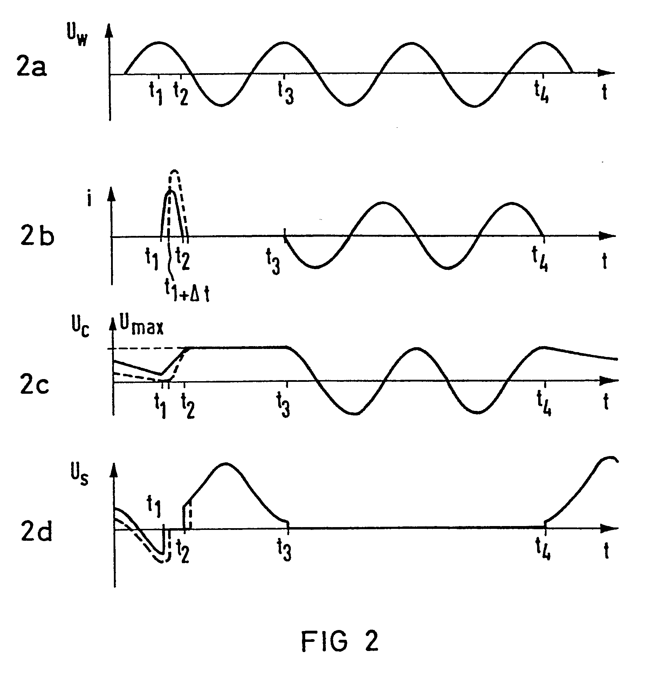

Wird über einen entsprechenden Befehlseingang 11 z.B. von einer Blindleistungsregelung ein entsprechender Befehl zum Ein- bzw. Ausschalten des Kondensators 3 gegeben, so spielen sich die in Fig. 2 schematisch dargestellten Vorgänge ab. Dabei können folgende Ablaufphasen unterschieden werden:
— Aufladen des Kondensators durch Schliessen des Schalters 5, z.B. indem das Ventil 5a während dieses Zeitintervalles $t_1$-$t_2$ gezündet ist;

— Schaltbereitschaft, d.h. Schalter 5 ist während des Zeitintervalles $t_2$-$t_3$ geöffnet;
— Betrieb mit eingeschaltetem Kondensator, d.h. der Schalter 5 ist durch alternierendes Zünden der Ventile 5a und 5b während des Zeitintervalles $t_3$-$t_4$ geschlossen;
— und Betrieb mit ausgeschaltetem Kondensator, d.h. ab Zeitpunkt $t_4$ ist der Schalter geöffnet.

Fig. 2a zeigt die Netzwechselspannung $U_w$,
Fig. 2b den durch die Reihenschaltung der Elemente 3, 4 und 5 fliessenden Strom,
Fig. 2c die Kondensatorspannung $U_c$, und
Fig. 2d die am Schalter 5 anliegende Spannung $U_s$.

Der Kondensator 3 soll so eingeschaltet werden, dass keine Einschwingvorgänge auftreten. Zu diesem Zweck ist der Kondensator auf eine entsprechende Maximalspannung $U_{max}$ aufzuladen und der Einschaltzeitpunkt $t_3$ so zu wählen, dass der Strom i sinusförmig verläuft. Da die Reihenschaltung 3, 4, 5 praktisch keinen ohmschen Widerstand besitzt, liegen die Spannungen $U_w$ und $U_c$ im Zeitintervall $t_3$-$t_4$ in Phase, während der Strom i dagegen um 90° voreilt. Der Einschaltzeitpunkt $t_3$ erfolgt bei einem Extremwert der sinusförmigen Spannungskurven $U_w$.

Das Abschalten des Kondensators 3 zum Zeitpunkt $t_4$ erfolgt ebenfalls frei von transienten Vorgängen bei einem Nulldurchgang der Stromschwingung und kann z.B. durch Unterdrückung eines Zündimpulses für das Ventil 5b bewirkt werden, wobei gleichzeitig wegen dieses Nulldurchganges das Thyristorventil 5a von selbst erlischt. Der hochohmige Entladungswiderstand 10 bewirkt nun eine exponentielle Entladung des Kondensators, wodurch für $t > t_4$ die Kondensatorspannung langsam abnimmt. Gleichzeitig baut sich am Schalter 5 die Schalterspannung $U_s = U_c - U_w$ auf.

Zum Abschalten des Kondensators ist es also lediglich nötig, dass auf einen entsprechenden Abschaltbefehl der Kompensationssteuerung die Zündimpulse für die beiden Thyristorventile 5a und 5b gesperrt werden. Für das überschwingungsfreie Einschalten muss der Kondensator vorher auf die Spannung $U_{max}$ aufgeladen werden.

Dies geschieht durch kurzfristiges Schliessen des Schalters 5 zum Zeitpunkt $t_1$. Der dabei entstehende Stromstoss kann als erste Halbperiode eines Einschwingvorganges aufgefasst werden, dessen Dauer die Schliessdauer des Schalters bestimmt. Wird z.B. zum Zeitpunkt $t_1$ das Thyristorventil 5a gezündet, so erlischt es zum Zeitpunkt $t_2$ von selbst. Die dadurch erfolgte Aufladung des Kondensators hängt von der Eigenfrequenz der Reihenschaltung 3, 4, 5, der Spannung des Kondensators vor dem Aufladen («Kondensatorrestspannung») und der Phase der Netzspannung ab. Bei gegebener Dimensionierung des Kondensators 3 und der Drosselspule 4 kann also für jeden Messwert der Kondensatorrestspannung der Ladeschliesszeitpunkt des Schalters 5 bezüglich der Phase der Netzwechselspannung, d.h. der Ladeschliesswinkel, so bestimmt werden, dass der Kondensator auf die Spannung $U_{max}$ aufgeladen wird. Die ausgezogenen Kurven in Fig. 2b bis 2d betreffen den Fall, dass noch eine erhebliche Kondensatorrestspannung vorhanden ist. Daneben ist in gestrichelten Kurven der Fall dargestellt, dass die Kondensatorrestspannung seit dem letzten Öffnen des Schalters praktisch auf Null abgeklungen ist. Durch Verschiebung des Ladeschliesszeitpunktes um $\Delta t$ kann auch in diesem Fall die Aufladung des Kondensators auf die Spannung $U_{max}$ erreicht werden. Für die meisten Werte der Kondensatorrestladung liegt der Ladeschliesszeitpunkt $t_1$ kurz hinter dem Amplitudendurchgang der Netzwechselspannung $U_w$. Der Schalter 5 muss daher nach dem Zeitpunkt $t_2$ mindestens eine ¾-Netzperiode geöffnet bleiben, bis die Netzwechselspannung wieder den Scheitelwert der gleichen Polarität erreicht hat und zum Zeitpunkt $t_3$ der Kondensator schwingungsfrei eingeschaltet werden kann.

Bei geöffnetem Schalter kann, wie aus Fig. 2d ersichtlich ist, die Phasenlage der Netzspannung aus dem Verlauf der Schalterspannung $U_s$ durch Subtraktion der Kondensatorspannung ermittelt werden. Es ist daher möglich (und in vielen Fällen schaltungsmässig günstiger) zur Bestimmung der Schliesszeitpunkte über das Phasenmessglied, die Schalterspannung anstelle der Netzwechselspannung zu erfassen.

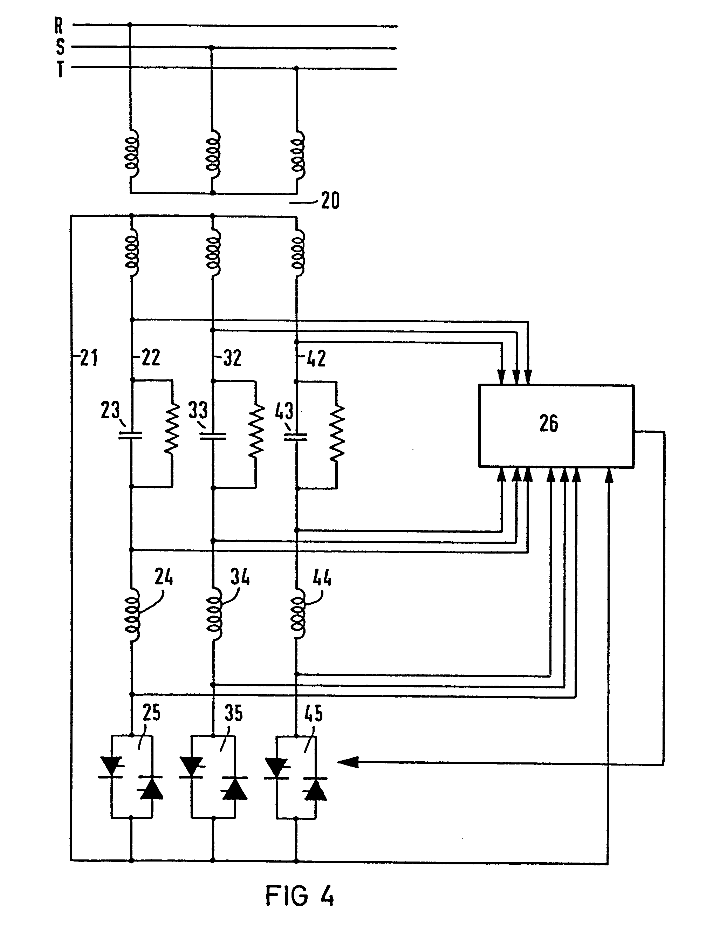

In Fig. 3 ist mit $U_{c1}$ bzw. $U_{c2}$ der Verlauf der Kondensatorspannung bezüglich der Netzwechselspannung $U_w$ genauer dargestellt für den Fall, dass zum Ladeschliesszeitpunkt der Kondensator vollkommen entladen bzw. die Kondensatorspannung auf $0{,}6 \cdot U_{max}$ abgeklungen ist. In Fig. 2c war angenommen worden, dass $U_{max}$ dem Scheitelwert $U_o$ der Netzwechselspannung entspricht. Zum schwingungsfreien Einschalten muss am Kondensator jedoch eine Spannung liegen, die bei eingeschaltetem Kondensator im eingeschwungenen Zustand der Kondensator-Scheitelspannung $U_{max} > U_o$ entspricht. $U_{max} = U_o$ gilt demnach nur, wenn in der Reihenschaltung zwischen den Leitern liegende Induktivitäten vernachlässigt werden können. Bei Verwendung von Thyristorventilen als Schalter ist jedoch eine Mindestgrösse für die Drossel 4 erforderlich, so dass sich bei geschlossenem Schalter (Zeitintervall $t_3$-$t_4$) der sinusförmige Verlauf der Spannung $U_c$ aus der Netzwechselspannung und der gegenüber $U_c$ gegenphasigen, von der Drosselspule induzierten Spannung $U_L$ zusammensetzt. Die Spannung $U_{max}$ und somit die Aufladung des Kondensators ist gegenüber dem Scheitelwert $U_o$ der Netzwechselspannung um $U_L$ erhöht, wie in Fig. 3 dargestellt ist. Ein Sonderfall liegt vor, wenn der Kondensator nur geringfügig entladen ist und von einer noch über $U_o$ liegenden Spannung aus auf $U_{max}$ aufgeladen werden muss. In diesem Fall muss in einem Schwingvorgang zuerst eine teilweise Entladung und anschliessend — durch Umkehrung der Stromflussrichtung — die Aufladung auf $U_{max}$ erfolgen.

In die Bestimmung des richtigen Schliesswinkels geht neben der gemessenen, momentanen Kondensatorspannung auch der von der Schaltung vorgegebene Wert des Wechselstromwiderstandes bzw. der Eigenfrequenz der Reihenschaltung ein. Werden mehrere Reihenschaltungen aus
Kondensatoren, Spulen und Schaltern zwischen
die beiden Phasen gelegt, so ist zur Bestimmung
der richtigen Ladeschliesswinkel und der Spannung $U_{max}$ jeweils zu berücksichtigen, wie viele
Kondensatoren bereits eingeschaltet sind und wie
viele beim nächsten Einschaltzeitpunkt zugeschaltet werden sollen.

Die bisher für ein einphasiges Wechselstromnetz beschriebene Schaltung kann auch für ein
Mehrphasen-Wechselstromnetz verwendet werden. Dabei können je zwischen zwei stromführende Phasen des Netzes eine entsprechende Reihenschaltung aus Kondensator, Schalter und ggf.
Drossel verwendet werden, es können aber die
entsprechenden Reihenschaltungen auch jeweils
zwischen einer Phase und einem Nulleiter angeordnet sein.

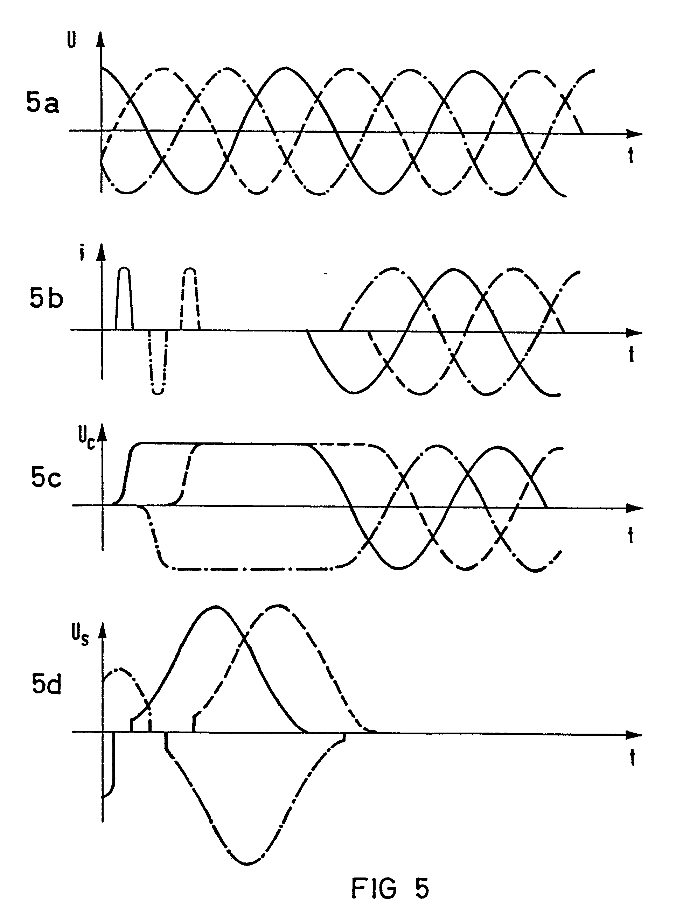

In Fig. 4 sind ein Dreiphasenwechselstromnetz
R, S, T und in Fig. 5a deren verkettete Spannungen
dargestellt. Mit 20 ist ein Transformator in Sternschaltung bezeichnet, an dessen Sekundärwicklungen die Leiterspannungen (Leiter 22, 32, 42)
der einzelnen Phasen gegenüber dem künstlichen
Sternpunkt (Leiter 21) auftreten und die jeweils
über eine Reihenschaltung aus Kondensatoren
(23, 33, 43), Drosselspulen (24, 34, 44) und Thyristorschalter (25, 35, 45) mit dem Nulleiter verbunden sind. Die Spannungen an den Kondensatoren sowie an den Schaltern werden einer zentralen Schaltsteuerung 26 zugeführt, die entsprechend der Phasenlage der einzelnen Leiterspannungen und der Kondensatorspannungen für jeden Schalter die Zeitpunkte zum Öffnen und
Schliessen ermittelt und entsprechende Schaltimpulse an die Schalter 25, 35, 45 abgibt. Die Ermittlung der Schaltzeitpunkte für eine dieser Reihenschaltungen kann dabei unabhängig von den anderen Reihenschaltungen erfolgen; werden jedoch anstelle eines Kondensators jeweils eine
Kondensatorbatterie verwendet, deren einzelne
Teilkondensatoren jeweils über eigene Schalter
zwischen den gleichen Leitern liegen, so sind, wie
bereits erläutert wurde, die Ladeschliesswinkel für
jeden der Teilkondensatoren in Abhängigkeit von
den Schaltzuständen der anderen Teilkondensatoren derselben Batterie zu ermitteln.

Das Abschalten der Kondensatoren 23, 33, 43
geschieht durch gleichzeitiges Wegnehmen aller
Zündimpulse für die Thyristoren der Schalter 25,
35, 45. Die Thyristoren erlöschen daher jeweils
beim Nulldurchgang des Stromes, d.h. zwei Kondensatoren werden jeweils bei maximaler Kondensatorspannung gleicher Polarität mit einer
120° entsprechenden Zeitverschiebung abgeschaltet, während der dritte Kondensator bei Maximalspannung entgegengesetzter Polarität bereits mit einer 60° entsprechenden Zeitverschiebung gegenüber dem ersten Kondensator abgeschaltet wird. Zum Wiedereinschalten werden die
Kondensatoren nunmehr durch entsprechendes
kurzzeitiges Schliessen ihrer Schalter auf die Maximalspannung der jeweiligen Polarität aufgeschaltet, wie das in Fig. 5b für den Fall verschwindender Kondensatorestladungen dargestellt ist.
In den Fig. 5c und 5d sind die Kondensatorspannungen und die Schalterspannungen entsprechend den Fig. 2 und 2d aufgetragen.

Die Bestimmung der zu den jeweiligen Kondensatorestspannungen gehörenden Ladeschliesswinkel geschieht nach Funktionen, die empirisch
oder rechnerisch als Lösung der Differentialgleichungen des Systems ermittelt werden können.
Die Zündwinkelsteuerung 6 bzw. 26 besteht also
hinsichtlich der Ermittlung der Ladeschliesswinkel
im wesentlichen aus einem Funktionsgeber, dem
entsprechende Kennlinien eingegeben sind. Vorteilhaft wird hierzu ein Mikroprozessor 7 (Fig. 2)
verwendet, der neben den Zündwinkeln auch die
Ermittlung der Phase der Netzspannung bzw. der
Schalterspannung aus den eingegebenen Messwerten vornimmt.

Besonders hervorzuheben ist hierbei der geringe
Aufwand für die Durchführung des Verfahrens.
Insbesondere sind bei der Verwendung zweier antiparalleler Thyristoren als Schalter keine Vorrichtungen zum Löschen der Thyristoren erforderlich,
da das Öffnen der Schalter jeweils mit einem Nulldurchgang des Stromverlaufes erfolgt, d.h. die
Thyristoren von selbst erlöschen.

## Patentansprüche

1. Verfahren zum überschwingungsfreien Ein-
und Ausschalten eines in Reihe mit einer Induktivität zwischen zwei Leitern (1, 2) eines Wechselspannungsnetzes liegenden Kondensators (3)
mittels eines in Reihe mit dem Kondensator liegenden Schalters (5) mit folgenden Verfahrensschritten:
a) durch kurzzeitiges Schliessen des Schalters (5)
wird der Kondensator von der Spannung ($U_w$)
zwischen den Leitern (Leiterspannung) in einer
Halbschwingung auf den Scheitelwert der betriebsmässigen Kondensatorspannung aufgeladen,
b) der aufgeladene Kondensator (3) wird durch
Schliessen des Schalters (5) eingeschaltet, wenn
die Spannung am Schalter ein Minimum erreicht,
c) zum Abschalten des Kondensators (3) wird der
Schalter (5) beim Nulldurchgang des durch den
Schalter fliessenden Stromes geöffnet, und
d) nach dem Öffnen des Schalters wird der Kondensator entladen,
gekennzeichnet durch die folgenden Merkmale:
e) das Entladen des Kondensators (3) erfolgt ungesteuert nach einer Entladecharakteristik (Widerstand 10), deren Zeitkonstante ein Vielfaches der
Wechselspannungsperiode beträgt, und
f) für die Kondensatoraufladung wird bezüglich
der Netzwechselspannung der Schliesszeitpunkt
des Schalters (5) (Ladeschliesswinkel) in Abhängigkeit der Spannung ($U_c$) am Kondensator in der
Weise bestimmt, dass auch bei einer noch vorhandenen Kondensatorrestspannung eine Aufladung
auf den Scheitelwert der betriebsmässigen Kondensatorspannung erfolgt.

2. Verfahren nach Anspruch 1, dadurch gekennzeichnet, dass bei einer in Reihe mit dem Kondensator (3) und dem Schalter (5) geschalteten Drosselspule (4) der Ladeschliesswinkel derart gewählt wird, dass unter Berücksichtigung der Eigenfrequenz der Reihenschaltung der Kondensator (3) auf eine derart über dem Scheitelwert der Wechselspannung liegende Spannung ($U_{max}$) aufgeladen wird, dass beim Einschalten des Kondensators keine Einschaltschwingungen auftreten.

3. Verfahren nach Anspruch 1 oder 2 zum Ein- und Ausschalten mehrerer Kondensatoren, die jeweils in Reihe mit einem entsprechenden Schalter zwischen den zwei Phasen des Wechselspannungsnetzes liegen, dadurch gekennzeichnet, dass der Ladeschliesswinkel jedes Schalters in Abhängigkeit von der Zahl der bereits eingeschalteten und der Zahl der noch einzuschaltenden Kondensatoren bestimmt wird.

4. Vorrichtung mit mindestens einer zwischen zwei Phasen (1, 2; 21, 22) eines Wechselspannungsnetzes angeordneten Reihenschaltung aus einem Kondensator (3; 23), einer Drosselspule (4; 24) und einem Schalter (5; 25), insbesondere einem Schalter aus zwei antiparallelen Thyristoren (5a, 5b), sowie mit einer Einrichtung (8) zum Erfassen der Kondensatorspannung, dadurch gekennzeichnet, dass zur Durchführung des Verfahrens nach einem der Ansprüche 1 bis 3 eine Schaltersteuerung (7) vorgesehen ist, die aus der Kondensatorspannung ($U_c$) in Verbindung mit dem von einem Phasenmessglied (9) ermittelten Phasenwinkel und ggf. unter Berücksichtigung der Schaltzustände weiterer zwischen den Phasen angeordneter entsprechender Reihenschaltungen den Schliesszeitpunkt des Schalters (5; 25) für die Kondensatoraufladung ermittelt.

## Revendications

1. Procédé pour la mise en et hors circuit, sans suroscillation, d'un condensateur (3) monté en série avec une inductance entre deux conducteurs (1, 2) d'un réseau de tension alternative, au moyen d'un commutateur (5) en série avec le condensateur, comportant les phases opératoires suivantes:
a) le condensateur est chargé, par fermeture temporaire du commutateur (5), jusqu'à la valeur de crête de la tension de service du condensateur, par la tension ($U_w$) entre les conducteurs (tension composée) pendant une alternance,
b) le condensateur chargé (3) est mis en circuit par fermeture du commutateur (5) lorsque la tension aux bornes du commutateur atteint un minimum,
c) le commutateur (5) est ouvert lors du passage par zéro du courant circulant dans le commutateur pour la mise hors circuit du condensateur (3), et
d) le condensateur est déchargé après l'ouverture du commutateur,
caractérisé par les caractéristiques suivantes:
e) la décharge du condensateur (3) a lieu sans être commandée, suivant une caractéristique de décharge (résistance 10) dont la constante de temps est égale à un multiple de la période de la tension alternative, et
f) pour la charge du condensateur, en ce qui concerne la tension alternative du réseau, l'instant de fermeture du commutateur (5) (angle final de charge) est déterminé en fonction de la tension ($U_c$) aux bornes du condensateur de manière que, même dans le cas où il existe encore une tension résiduelle aux bornes du condensateur, une charge ait lieu jusqu'à la valeur de crête de la tension de service du condensateur.

2. Procédé suivant la revendication 1, caractérisé par le fait que dans le cas où une bobine d'arrêt (4) est montée en série avec le condensateur (3) et le commutateur (5), l'angle final de charge est choisi de manière que, en tenant compte de la fréquence propre du circuit série, le condensateur (3) soit chargé jusqu'à une tension ($U_{max}$) supérieure à la valeur de crête de la tension alternative, de manière qu'aucun phénomène transitoire n'apparaisse lors de la mise en circuit du condensateur.

3. Procédé suivant la revendication 1 ou 2, pour la mise en et hors circuit de plusieurs condensateurs qui sont montés respectivement en série avec un commutateur correspondant entre les deux phases du réseau de tension alternative, caractérisé par le fait que l'angle final de charge de chaque commutateur est déterminé en fonction du nombre des condensateurs déjà en circuit et du nombre des condensateurs devant encore être mis en circuit.

4. Dispositif comportant au moins un circuit série, qui est constitué par un condensateur (3; 23), une bobine d'arrêt (4; 24) et un commutateur (5; 25), notamment un commutateur constitué par deux thyristors (5a, 5b) branchés en antiparallèle, monté entre deux phases (1, 2; 21, 22) d'un réseau de tension alternative, ainsi qu'un dispositif (8) pour déterminer la tension aux bornes du condensateur, caractérisé par le fait que pour la mise en œuvre du procédé suivant l'une des revendications 1 à 3, il est prévu un circuit de commande (7) du commutateur qui détermine l'instant de fermeture du commutateur (5; 25) pour la charge du condensateur, à partir de la tension ($U_c$) aux bornes du condensateur, en liaison avec l'angle de phase déterminé par un élément de mesure phase (9) et éventuellement en tenant compte des états de commutation d'autres circuits série correspondants montés entre les phases.

## Claims

1. Process for the overswing-free switching-on and switching-off of a capacitance (3) lying in series with an inductance between two conductors (1, 2) of an alternating current voltage circuit, by means of a switch (5) lying in series with the capacitance, with the following process steps:
a) by the short-term closing of the switch (5) the capacitance is charged from the voltage ($U_w$)

between the conductors (line to line voltage) in a semi-oscillation to the peak value of the operative capacitance voltage,

b) the charged capacitance (3) is switched-on by closing the switch (5) when the voltage at the switch reaches a minimum,·

c) for switching-off the capacitance (3) the switch (5) is opened during zero passage of the current flowing through the switch; and

d) after opening the switch the capacitance is discharged, characterised by the following features:

e) discharging of the capacitance (3) is effected uncontrolled according to a discharging characteristic (resistance 10), the time constant of which is a multiple of the alternating current voltage period, and

f) for the capacitance charging the closing moment of the switch (5) (charging closing angle), with respect to the alternating current voltage from the mains, is determined in dependence on the voltage ($U_c$) at the capacitance in such a way that even when there is a residual capacitance voltage still present, charging is effected to the peak value of the operative capacitance voltage.

2. Process according to claim 1, characterised in that with an impedance coil (4) connected in series with the capacitance (3) and the switch (5), the charging closing angle is selected in such a way that, when taking into account the inherent frequency of the series connection, the capacitance (3) is charged to a voltage ($U_{max}$) above the peak value of the alternating current voltage such that when the capacitance is switched-on, no switch-on oscillations occur.

3. Process according to claim 1 or 2 for the switching-on and switching-off of several capacitances which are respectively in series with a corresponding switch between the two phases of the alternating current voltage circuit, characterised in that the charging closing angle of each switch is determined in dependence on the number of capacitances already switched-on and the number of capacitances still to be switched-on.

4. Device with at least one series connection, arranged between two phases (1, 2; 21, 22) of an alternating current voltage circuit, of a capacitance (3; 23), an impedance coil (4; 24) and a switch (5; 25), in particular a switch of two anti-parallel thyristors (5a, 5b), as well as a device (8) for picking up the capacitance voltage, characterised in that for carrying out the process according to one of claims 1 to 3 there is provided a switch control (7), which determines the closing moment of the switch (5; 25) for the capacitance charging, from the capacitance voltage ($U_c$) in connection with the phase angle determined by a phase measuring element (9) and if necessary taking into account the switching states of further corresponding series connections arranged between the phases.

FIG 1

FIG 3

FIG 2

FIG 4

FIG 5